(19) Europäisches Patentamt
European Patent Office
Office européen des brevets

(11) **EP 4 737 928 A1**

(12) **EUROPEAN PATENT APPLICATION**

(43) Date of publication:
06.05.2026  Bulletin 2026/19

(21) Application number: 25208044.5

(22) Date of filing: 10.10.2025

(51) International Patent Classification (IPC):
*G01R 31/396* (2019.01)   *G01R 31/52* (2020.01)
*H01M 10/48* (2006.01)

(52) Cooperative Patent Classification (CPC):
H01M 10/482; G01R 31/396; G01R 31/52

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 30.10.2024  KR 20240151255

(71) Applicant: SAMSUNG SDI CO., LTD.
Yongin-si, Gyeonggi-do 17084 (KR)

(72) Inventor: Okui, Yoshiaki
Yongin-si, Gyeonggi-do 17084 (KR)

(74) Representative: Gulde & Partner
Patent- und Rechtsanwaltskanzlei mbB
Berliner Freiheit 2
10785 Berlin (DE)

(54) **METHOD AND APPARATUS FOR DETECTING INSULATION DEFECT OF BATTERY, AND BATTERY SYSTEM**

(57)     A method for detecting an insulation defect in a battery may be provided. The method for detecting insulation defect includes measuring a first voltage corresponding to a voltage of a positive terminal of a battery rackduring a first duration; measuring a second voltage corresponding to a voltage of the positive terminal of the battery rack and a third voltage corresponding to a voltage of a negative terminal of the battery rack, respectively, during a second duration; measuring a fourth voltage corresponding to a voltage of the negative terminal of the battery rack during a third duration; measuring an insulation resistance value of the battery rack based on the first voltage and the fourth voltage; and determining whether the battery rack has the insulation defect based on the insulation resistance value of the battery rack.

FIG. 2

EP 4 737 928 A1

## Description

### FIELD

This disclosure relates to a method and apparatus for detecting insulation defect in a battery, and a battery system.

### BACKGROUND

An energy storage system (ESS) may include a plurality of battery cells. If an insulation defect in even one of the plurality of battery cells occurs, it may lead to a fire. Therefore, it is important to monitor the insulation status of the battery cells.

The most widely used insulation monitoring method today is the method of using an insulation monitoring device (IMD), which may monitor the insulation status through changes in the insulation resistance if insulation breakdown or insulation deterioration occurs. Therefore, it is difficult to accurately find the position of insulation defect in ESS where the plurality of battery cells are connected in series and/or parallel.

### SUMMARY

The invention is defined by the appended claims. The description that follows is subjected to this limitation. Any disclosure lying outside the scope of said claims is only intended for illustrative as well as comparative purposes.

At least embodiments provide a method and apparatus for detecting an insulation defect in a battery, and a battery system, capable of specifying a position of the insulation defect.

According to an aspect of the present invention, a method for detecting an insulation defect is provided. The method for detecting the insulation defect includes: measuring a first voltage corresponding to a voltage of a positive terminal of a battery rack during a first duration; measuring a second voltage corresponding to a voltage of the positive terminal of the battery rack and a third voltage corresponding to a voltage of a negative terminal of the battery rack, respectively, during a second duration; measuring a fourth voltage corresponding to the voltage of the negative terminal of the battery rack during a third duration; measuring an insulation resistance value of the battery rack based on the first voltage and the fourth voltage; and determining whether the battery rack has the insulation defect based on the insulation resistance value of the battery rack.

The method for detecting insulation defect may further include detecting a position of the insulation defect in the battery rack using the second voltage and the third voltage if the battery rack is determined to have defective insulation.

The detecting the position of the insulation defect may include: calculating a ground fault voltage using the second voltage, the third voltage, and the insulation resistance value; calculating a voltage between the positive terminal of the battery rack and ground using the ground fault voltage and the second voltage; calculating the relative position of the insulation defect using the ground fault voltage and the voltage between the positive terminal of the battery rack and ground; and specifying a position of the insulation defect from the relative position of the insulation defect.

The relative position of the insulation defect may indicate a ratio of a distance between the negative terminal of the battery rack and the positive terminal of the battery rack and a distance from a position of the negative terminal of the battery rack to the position of the insulation defect, as a percentage (%).

The specifying a position of the insulation defect may include specifying the position of the negative terminal of the battery rack as the position of the insulation defect if the relative position of the insulation defect is 0%; specifying the position of the positive terminal of the battery rack as the position of the insulation defect if the relative position of the insulation defect is 100%; and specifying a middle position between the negative terminal of the battery rack and the positive terminal of the battery rack as the position of the insulation defect if the relative position of the insulation defect is 50%.

The measuring the first voltage during the first duration may include turning on a first switch connected between the positive terminal of the battery rack and an inverting input terminal of a first operational amplifier, the measuring the fourth voltage during the third duration may include turning on a second switch connected between the negative terminal of the battery rack and an inverting input terminal of a second operational amplifier, and measuring the second voltage and the third voltage during the second duration may include turning on the first switch and the second switch simultaneously.

According to another aspect of the present invention, an insulation defect detection apparatus is provided. The insulation defect detection apparatus includes: a first voltage meter configured to measure a voltage of a positive terminal of a battery rack; a second voltage meter configured to measure a voltage of a negative terminal of the battery rack; a controller configured to measure the voltage of the positive terminal as a first voltage during a first duration, measure the voltage of the positive terminal and the voltage of the negative terminal as a second voltage and a third voltage respectively during a second duration, and measure the voltage of the negative terminal as a fourth voltage during a third duration; and

an insulation resistance meter configured to detect an insulation status of the battery rack using the first voltage, the second voltage, the third voltage, and the fourth voltage.

The insulation resistance meter may be configured to measure an insulation resistance value of the battery rack based on the first voltage and the fourth voltage, and determine that an insulation of the battery rack is defective if the insulation resistance value of the battery rack is lower than or equal to a set threshold value.

The insulation resistance meter may be configured to detect a position of the insulation defect in the battery rack using the second voltage and the third voltage if the battery rack is determined to have defective insulation based on the insulation resistance value of the battery rack.

The insulation resistance meter may be configured to calculate a ground fault voltage using the second voltage, the third voltage, and the insulation resistance value, calculate a voltage between the positive terminal of the battery rack and ground using the ground fault voltage and the second voltage, calculate a relative position of the insulation defect using the ground fault voltage and the voltage between the positive terminal of the battery rack and ground, and specify the position of the insulation defect from the relative position of the insulation defect.

The relative position of the insulation defect may indicate a ratio of a distance between the negative terminal of the battery rack and the positive terminal of the battery rack and a distance from a position of the negative terminal of the battery rack to the position of the insulation defect, as a percentage (%).

The insulation resistance meter may be configured specify the position of the negative terminal of the battery rack as the position of the insulation defect if the relative position of the insulation defect is 0%, specify the position of the positive terminal of the battery rack as the position of the insulation defect if the relative position of the insulation defect is 100%, and specify a middle position between the negative terminal of the battery rack and the positive terminal of the battery rack as the position of the insulation defect if the relative position of the insulation defect is 50%.

The first voltage meter may be configured to include a first operational amplifier and a first switch connected between a first input terminal of the first operational amplifier and the positive terminal of the battery rack, the second voltage meter may be configured to include a second operational amplifier and a second switch connected between a second input terminal of the second operational amplifier and the negative terminal of the battery rack, and the controller may be configured to turn on only the first switch during the first duration, maintain an on state of the first switch and turn on the second switch during the second duration, and turn off the first switch and maintain anon state of the second switch during the third duration.

According to a further aspect of the invention, a battery system is provided. The battery system includes: a battery rack configured to include a plurality of battery cells; and a rack battery management system configured to measure a voltage of a positive terminal as a first voltage during a first duration, measure the voltage of the positive terminal and a voltage of a negative terminal as a second voltage and a third voltage respectively during a second duration after the first duration, measure the voltage of the negative terminal as a fourth voltage during a third duration after the second duration, and detect an insulation status of the battery rack using the first voltage, the second voltage, the third voltage, and the fourth voltage.

The rack battery management system may be configured to measure an insulation resistance value of the battery rack based on the first voltage and the fourth voltage, and determine that an insulation of the battery rack is defective if the insulation resistance value of the battery rack is lower than or equal to a set threshold value.

The rack battery management system may be configured to detect a position of the insulation defect in the battery rack using the second voltage and the third voltage if the battery rack is determined to have defective insulation based on the insulation resistance value of the battery rack.

The rack battery management system may be configured to calculate a ground fault voltage using the second voltage, the third voltage, and the insulation resistance value, calculate a voltage between the positive terminal of the battery rack and ground using the ground fault voltage and the second voltage, calculate a relative position of the insulation defect using the ground fault voltage and the voltage between the positive terminal of the battery rack and ground, and specify the position of the insulation defect from the relative position of the insulation defect.

The relative position of the insulation defect may indicate a ratio of a distance between the negative terminal of the battery rack and the positive terminal of the battery rack and a distance from a position of the negative terminal of the battery rack to the position of the insulation defect, as a percentage (%).

The rack battery management system may be configured to include: a first voltage meter configured to include a first operational amplifier and a first switch connected between a first input terminal of the first operational amplifier and the positive terminal of the battery rack, and measure the voltage of the positive terminal of the battery rack if the first switch is turned on; a second voltage meter configured to include a second operational amplifier and a second switch connected between a second input terminal of the second operational amplifier and the negative terminal of the battery rack, and measure the voltage of the negative terminal of the battery rack if the second switch is turned on; and a controller configured to turn on only the first switch during the first duration, maintain an on state of the first switch and turn on the second switch during the second duration, and turn off the first switch and maintain an on state of the second switch during the third duration.

## BRIEF DESCRIPTION OF THE DRAWINGS

FIG. 1 is a diagram illustrating an energy storage system according to embodiments.
FIG. 2 is a diagram showing an apparatus for detecting an insulation defect according to embodiments.
FIG. 3 is a diagram showing the switching timing for insulation resistance measurement according to embodiments.
FIG. 4 is a flow chart showing an insulation resistance measurement method according to embodiments.
FIGS. 5 and 6 are diagrams showing simulation results of insulation defect detection of a battery insulation defect detection apparatus according to embodiments, respectively.
FIG. 7 is a diagram showing a battery insulation defect detection apparatus according to embodiments.

## DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art. The drawings and description are to be regarded as illustrative in nature and not restrictive. Like reference numerals designate like elements throughout the specification. In the flowchart described with reference to the drawings in this specification, the order of operations may be changed, several operations may be merged, some operations may be divided, and specific operations may not be performed.

Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

In addition, terms including an ordinal number, such as first, second, etc., may be used to describe various elements, but the elements are not limited by the terms. The herein terms are used only for the purpose of distinguishing one element from another element. For example, without departing from the scope of the present disclosure, a first element may be referred to as a second element, and similarly, a second element may be referred to as a first element.

Furthermore, if a component is referred to be "connected" with another component, it includes not only the case where two components are "directly connected" but also the case where two components are "indirectly or non-contactedly connected" with another component interposed therebetween, or the case where two components are "electrically connected." On the other hand, if an element is referred to as "directly connected" to another element, it should be understood that no other element exists in the middle.

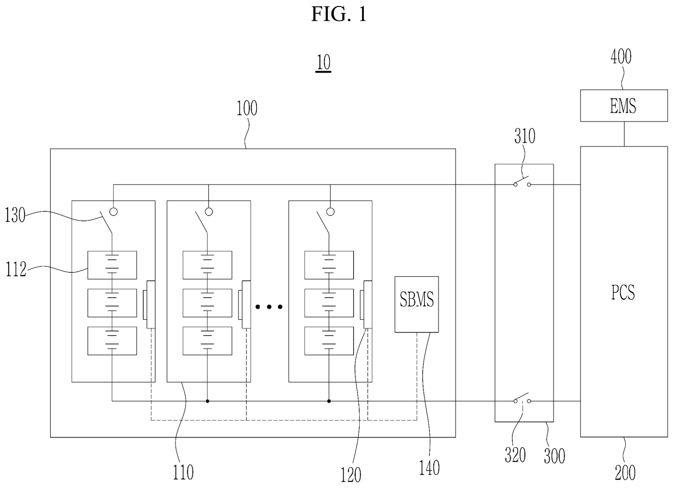

FIG. 1 is a diagram illustrating an energy storage system according to embodiments.

Referring to FIG. 1, the energy storage system 10 may include a battery system 100, a power conversion system (PCS) 200, a switching part 300, and an energy management system (EMS) 400.

The battery system 100 may be charged by receiving power from a grid or power generation system, and may be discharged to supply power to a load or grid.

The battery system 100 may include a plurality of battery racks 110, a plurality of rack battery management systems (RBMSs) 120, a plurality of rack switches 130, and a system BMS (SBMS) 140.

The battery rack 110 may include a plurality of battery modules 112. The battery module 112 may include a plurality of battery cells. The battery cell may be the minimum unit of a battery system. Here, depending on the device or system in which the battery system 100 is used, the battery rack 110 may also be referred to as a battery pack.

The plurality of RBMSs 120 may be connected to the plurality of battery racks 110, respectively, and may monitor the plurality of battery racks 110. The plurality of RBMSs 120 may measure or collect status information of the corresponding battery rack 110 and/or battery cells such as currents, voltages, temperatures, status of charge (SOC), status of health (SOH), depth of discharge (DOD), maximum power, and capacities of the corresponding battery rack 110 and/or battery cells, and transmit the status information to the SBMS 140. In addition, the plurality of RBMSs 120 may control charging and discharging of the battery rack 110 and perform balancing operations, under the control of the SBMS 140. Each of the plurality of RBMSs 120 may control each of the plurality of rack switches 130.

Each of the plurality of rack switches 130 may be connected between the positive terminal of each of the plurality of battery racks 110 and the switching part 300. The plurality of rack switches 130 may be turned on or off according to the control of a plurality of RBMSs 120, respectively.

The SBMS 140 may perform various control functions, such as charge and discharge control and balancing of the plurality of battery racks 110, based on status information of the plurality of battery racks 110, and may transmit control signals for controlling the plurality of battery racks 110 to the plurality of RBMS 120.

The PCS 200 may be connected to the battery system 100. In addition, the PCS 200 may be connected to a grid, a power generation system, and a load. The PCS 200 may convert the characteristics of power between the battery system 100 and the power generation system, or between the battery system 100 and the grid. The characteristics of power may include frequency, voltage, current, alternating current (AC), direct current (DC), etc. As an example, the PCS 200 may convert AC power supplied from the grid into DC power and supply the converted DC power to the battery system 100. As another example, the PCS 200 may convert DC power supplied from the battery system 100 into AC power and supply the converted AC power to the load.

The switching part 300 may be connected between the battery system 100 and the PCS 200. The switching part 300 may include a first switch 310 connected between the positive terminals of the battery racks 110 and the PCS 200 and a second switch 320 connected between the negative terminals of the battery racks 110 and the PCS 200. The switching part 300 may control the first switch 310 and the second switch 320.

The EMS 400 may monitor the status of the battery system 100. The EMS 400 may monitor the status of the grid, power generation system, and PCS 200. The EMS 400 may monitor the amount of power stored in the energy storage system 10. The EMS 400 may determine the total charging power and total discharging power of the energy storage system 10 based on the amount of power generated in the grid or power generation system and the amount of power stored in the energy storage system 10, and may determine the operation mode of the energy storage system 10. The operating modes may include, for example, a charge mode, a discharge mode, and an idle mode. As an example, the EMS 400 may determine whether the battery system 100 is charged and/or discharged based on the difference between the amount of power delivered to the load from the battery system 100 and the amount of power generated in the grid or power generation system, and may determine the operation mode depending on whether the battery system 100 is charged and/or discharged.

The EMS 400 may manage data such as total charging power, total discharging power, and operating history of the energy storage system 10. The EMS 400 may operate the energy storage system 10 and may be an operating system for controlling the energy storage system 10.

In this way, the energy storage system 10 includes the plurality of battery racks 110. If an insulation defect in even one of the plurality of battery cells in the plurality of battery racks 110 occurs, there is a possibility that a fire may occur, so it is important to monitor the insulation status of the battery cells.

According to embodiments, the each of the plurality of RBMSs 120 may monitor the insulation status of the plurality of battery cells within the plurality of battery racks 110, respectively. The each of the plurality of RBMS 120 may measure the insulation resistance value of the corresponding battery rack 110, and may diagnose insulation defect of the corresponding battery rack 110 based on the measured insulation resistance value of the corresponding battery rack 110.

For example, if the insulation status of the battery rack 110 is well maintained, the measured insulation resistance value has a sufficiently large value. On the other hand, if the insulation status n of the battery rack 110 is poor, the measured insulation resistance value becomes very small, below the allowable value. Accordingly, each of the plurality of RBMSs 120 may measure the insulation resistance value of the corresponding battery rack 110 and detect insulation defect of the battery rack 110 based on the measured insulation resistance value of the battery rack 110. Furthermore, the plurality of RBMSs 120 may detect the position of insulation defect in the corresponding battery rack 110 if insulation defect of the corresponding battery rack 110 is detected.

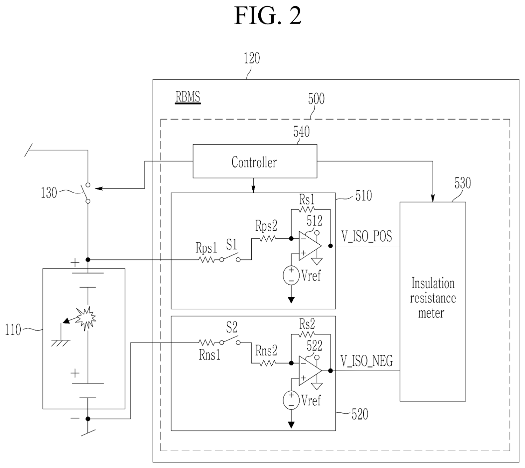

FIG. 2 is a diagram showing an apparatus for detecting an insulation defect according to embodiments.

FIG. 2 illustrates an insulation defect detection apparatus 500 that detects the insulation status of one battery rack 110 among the plurality of battery racks 110.

Referring to FIG. 2, the insulation defect detection apparatus 500 may include a first voltage meter 510, a second voltage meter 520, an insulation resistance meter 530, and a controller 540. The insulation defect detection apparatus 500 may be implemented within the RBMS 120.

The first voltage meter 510 may be connected to the positive terminal + of the battery rack 110 and may measure a voltage of the positive terminal + of the battery rack 110.

The first voltage meter 510 may include a resistor Rps1, a switch S1, a resistor Rps2, an operational amplifier 512, and a resistor Rs1.

In the first voltage meter 510, one end of the resistor Rps1 may be connected to the positive terminal + of the battery rack 110, and the switch S1 may be connected between the other end of the resistor Rps1 and one end of the resistor Rps2. The other end of the resistor Rps2 may be connected to an inverting input terminal - of the operational amplifier 512. A reference voltage Vref may be input to a noninverting input terminal + of the operational amplifier 512. The resistor Rs1 may be connected between the inverting input terminal - of the operational amplifier 512 and an output terminal of the operational amplifier 512, and the output terminal of the operational amplifier 512 may be connected to an insulation resistance meter 530. That is, the output voltage V_ISO_POS of the operational amplifier 512 may be provided to the insulation resistance meter 530.

In the first voltage meter 510, if the switch S1 is turned on, the positive terminal + of the battery rack 110 is connected to the inverting input terminal - of the operational amplifier 512 through the resistors Rps1 and Rps2. The operational amplifier 512 may output a voltage V_ISO_POS corresponding to the voltage of the positive terminal + of the battery rack 110.

That is, if the switch S1 is turned on, the first voltage meter 510 may provide the voltage V_ISO_POS corresponding to the voltage of the positive terminal + of the battery rack 110 to the insulation resistance meter 530.

The second voltage meter 520 may be connected to the negative terminal - of the battery rack 110 and may measure a voltage of the negative terminal - of the battery rack 110.

The second voltage meter 520 may include a resistor Rns1, a switch S2, a resistor Rns2, an operational amplifier 522, and a resistor Rs2.

In the second voltage meter 520, one end of the resistor Rns1 may be connected to the negative terminal - of the battery rack 110, and the switch S2 may be connected between the other end of the resistor Rns1 and one end of the resistor Rns2. The other end of the resistor Rns2 may be connected to an inverting input terminal - of the operational amplifier 522. The reference voltage Vref may be input to a noninverting input terminal + of the operational amplifier 522. The resistor Rs2 may be connected between the inverting input terminal - of the operational amplifier 522 and an output terminal of the operational amplifier 522, and the output terminal of the operational amplifier 522 may be connected to an insulation resistance meter 530. That is, the output voltage V_ISO_NEG of the operational amplifier 522 may be provided to the insulation resistance meter 530.

In the second voltage meter 520, if the switch S2 is turned on, the negative terminal - of the battery rack 110 is connected to the inverting input terminal - of the operational amplifier 522 through the resistors Rns1 and Rns2. The operational amplifier 522 may output a voltage V_ISO_NEG corresponding to the voltage of the negative terminal - of the battery rack 110.

That is, if the switch S2 is turned on, the second voltage meter 520 may provide the voltage V_ISO_ NEG corresponding to the voltage of the negative terminal - of the battery rack 110 to the insulation resistance meter 530.

If the controller 540 wants to diagnose the insulation status of the battery rack 110, it may control the rack switch 130 and switches S1 and S2. If the controller 540 wants to diagnose the insulation status of the battery rack 110, it may set the rack switch 130 connected to the battery rack 110 to be diagnosed to the off state. The controller 540 sequentially sets the rack switches 130 connected to each of the plurality of battery racks 110 to the off state, and may sequentially diagnose the insulation status of the plurality of battery racks 110, thereby specifying(identifying) the battery rack 110 in which the insulation defect has occurred. In addition, the controller 540 may control the turning on and off of the switches S1 and S2 to diagnose the insulation status of the battery rack 110.

According to embodiments, the controller 540 may turn on the switch S1 and turn off the switch S2 in a first duration to diagnose the insulation state of the battery rack 110, turn on the switch S2 in a second duration, which is continuous with the first duration, and turn off the switch S1 in a third duration, which is continuous with the second section to turn on only the switch S2.

The insulation resistance meter 530 may obtain a voltage V_ISO_POS corresponding to the voltage of the positive terminal + of the battery rack 110 measured by the first voltage meter 510 in the first duration, may obtain a voltage V_ISO_POS corresponding to the voltage of the positive terminal + of the battery rack 110 measured by the first voltage meter 510 and a voltage V_ISO_NEG corresponding to the voltage of the negative terminal - of the battery rack 110 measured by the second voltage meter 520 in the second duration, and may obtain a voltage V_ISO_NEG corresponding to the voltage of the negative terminal - of the battery rack 110 measured by the second voltage meter 520 in the third duration.

The insulation resistance meter 530 may measure the insulation resistance of the battery rack 110 by using the voltage V_ISO_POS corresponding to the voltage of the positive terminal + of the battery rack 110 measured by the first voltage meter 510 in the first section and the voltage V_ISO_NEG corresponding to the voltage of the negative terminal - of the battery rack 110 measured by the second voltage meter 520 in the third section.

The insulation resistance meter 530 may diagnose the insulation status of the battery rack 110 based on the measured insulation resistance value of the battery rack 110.

In addition, if an insulation defect of the battery rack 110 is detected, the insulation resistance meter 530 may detect the position of the insulation defect in the battery rack 110 by using the voltage V_ISO_POS corresponding to the voltage of the positive terminal + of the battery rack 110 and the voltage V_ISO_NEG corresponding to the voltage of the negative terminal - of the battery rack 110 measured by the first voltage meter 510 and the second voltage meter 520, respectively in the second duration.

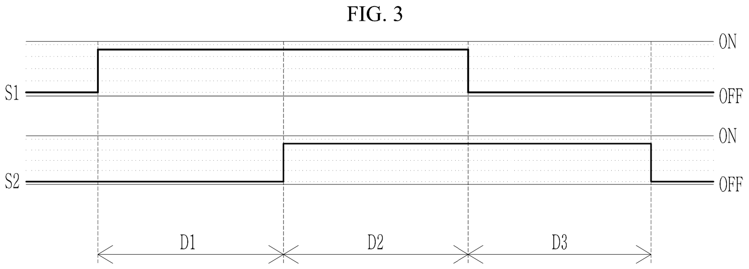

FIG. 3 is a diagram showing the switching timing for insulation resistance measurement according to embodiments.

Referring to FIG. 3, the controller 540 may turn on the switch S1 and turn off the switch S2 in the first duration D1 of the insulation measurement duration. Then, the first voltage meter 510 may measure a voltage V_ISO_POS corresponding to the voltage of the positive terminal + of the battery rack 110 in the first duration D1, and output the voltage V_ISO_POS measured in the first duration D1 to the insulation resistance meter 530.

Next, the controller 540 may turn on the switch S2 in the second duration D2 of the insulation measurement duration. Then, the first voltage meter 510 may measure a voltage V_ISO_POS corresponding to the voltage of the positive terminal + of the battery rack 110 in the second duration D2, and output the voltage V_ISO_POS measured in the second duration D2 to the insulation resistance meter 530. In addition, the second voltage meter 520 may measure a voltage V_ISO_NEG corresponding to the voltage of the negative terminal - of the battery rack 110 in the second duration D2, and output the voltage V_ISO_NEG measured in the second duration D2 to the insulation resistance meter 530.

Next, the controller 540 may turn off the switch S1 in the third duration D3. Then, the second voltage meter 520 may measure a voltage V_ISO_NEG corresponding to the voltage of the negative terminal - of the battery rack 110 in the third duration D3, and output the voltage V_ISO_NEG measured in the third duration D3 to the insulation resistance meter 530.

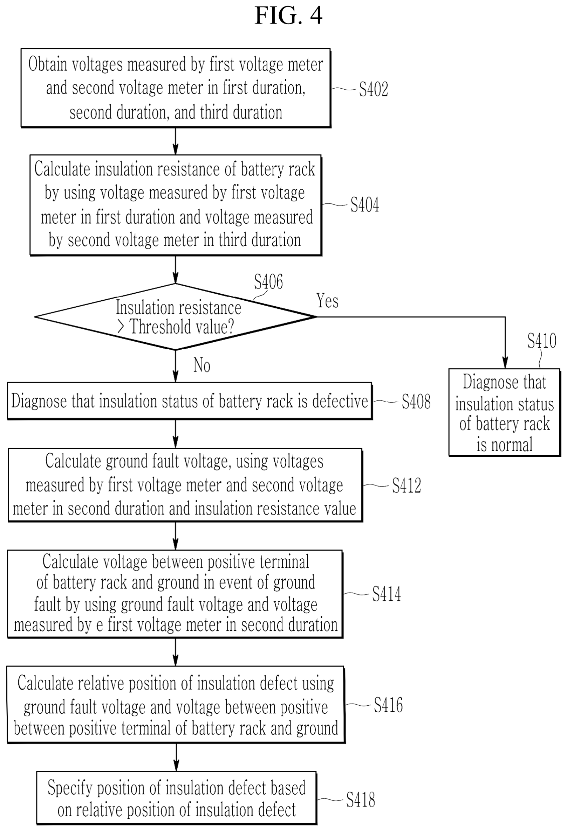

FIG. 4 is a flow chart showing an insulation resistance measurement method according to embodiments.

Referring to FIG. 4, the insulation resistance meter 530 may obtain the voltage V_ISO_POS measured by the first voltage meter 510 in the first duration D1, the voltage V_ISO_POS measured by the first voltage meter 510 and the voltage V_ISO_NEG measured by the second voltage meter 520 in the second duration D2, and the voltage V_ISO_NEG measured by the second voltage meter 520 in the third duration D3 (S402).

The insulation resistance meter 530 may calculate the insulation resistance of the battery rack 110 by using the voltage V_ISO_POS measured by the first voltage meter 510 in the first duration D1 and the voltage V_ISO_NEG measured by the second voltage meter 520 in the third duration D3 (S404).

In some embodiments, the insulation resistance of the battery rack 110 may be calculated as shown in Equation 1.

(Equation 1)

$$\text{Riso} = \left( \frac{Vbat}{V\_ISO\_NEG - V\_ISO\_POS} \times Rs1 \right) - \text{Rsp1} - \text{Rsp2}\ [\Omega]$$

In Equation 1, Riso represents the insulation resistance of the battery rack 110, and Vbat may represent the voltage of the battery rack 110. Additionally, V_ISO_POS may represent a voltage measured by the first voltage meter 510 in the first duration D1, and V_ISO_NEG may represent a voltage measured by the second voltage meter 520 in the third duration D3.

The insulation resistance meter 530 may compare the insulation resistance of the battery rack 110 with a set threshold value.

The insulation resistance meter 530 may diagnose that the insulation status of the battery rack 110 is defective (S408), if the insulation resistance of the battery rack 110 is less than or equal to the threshold value (S406).

The insulation resistance meter 530 may diagnose that the insulation status of the battery rack 110 is normal if the insulation resistance of the battery rack 110 is greater than the threshold value (S410).

Meanwhile, if the insulation status of the battery rack 110 is diagnosed as insulation defect, the insulation resistance meter 530 may detect the position of the insulation defect in the battery rack 110. The position of the insulation defect may be detected based on Equation 2.

(Equation 2)

$$\text{Pos} = \frac{(\text{Vbat} - (\text{Vp} - \text{Viso}))}{Vbat} \times 100[\%]$$

In Equation 2, Pos may represent the relative position of insulation defect. Vp may represent the voltage between the positive terminal + of the battery rack 110 and the ground in the event of a ground fault due to the insulation defect, and may be calculated as in Equation 3. Additionally, Viso may represent ground fault voltage and may be calculated as shown in Equation 4.

(Equation 3)

$$\text{Vp} = \left\{ 1 + \frac{(Rps1 + Rps2)}{Rs1} \right\} \times \text{Vref} - \frac{(Rps1 + Rps2)}{Rs1} \times \text{V\_ISO\_POS}\ [V]$$

In Equation 3, V_ISO_POS may represent a voltage measured by the first voltage meter 510 in the second

duration D2.

(Equation 4)

$$Viso = \frac{(V\_ISO\_POS + V\_ISO\_NEG - 2 \times Vref)}{Rs1} \times Riso \ [V]$$

In Equation 4, V_ISO_POS may represent a voltage measured by the first voltage meter 510 in the second duration D2, and V_ISO_NEG may represent a voltage measured by the second voltage meter 520 in the second duration D2.

In Equation 2, the Pos may be expressed a ratio of a distance between the negative terminal - of the battery rack 110 and the positive terminal + of the battery rack 110 and a distance from a position of the negative terminal - of the battery rack 110 to the position of the insulation, as a percentage (%). For example, if the relative position Pos of the insulation defect is 0%, it may indicate that the insulation defect has occurred at the position of the negative terminal - of the battery rack 110)

If the relative position Pos of the insulation defect is 50%, it may indicate that the insulation defect has occurred at the middle position between the negative terminal - of the battery rack 110 and the positive terminal + of the battery rack 110. If the relative position Pos of the insulation defect is 100%, it may indicate that insulation defect has occurred at the position of the positive terminal + of the battery rack 110.

That is, if the insulation resistance meter 530 diagnoses that the insulation status of the battery rack 110 is defective, it may calculate the ground fault voltage using the voltage V_ISO_POS measured by the first voltage meter 510 in the second duration D2, the voltage V_ISO_NEG measured by the second voltage meter 520 in the second duration D2, and the insulation resistance value calculated based on Equation 1 (S412).

The insulation resistance meter 530 may calculate the voltage between the positive terminal + of the battery rack 110 and the ground in the event of a ground fault by using the ground fault voltage and the voltage V_ISO_POS measured by the first voltage meter 510 in the second duration D2 (S414).

Next, the insulation resistance meter 530 may calculate the relative position Pos of insulation defect using the ground fault voltage and the voltage between the positive terminal + of the battery rack 110 and the ground as in Equation 2 (S416).

The insulation resistance meter 530 may specify the position of the insulation defect based on the relative position of the insulation defect (S418).

For example, the insulation resistance meter 530 may determine that an insulation defect has occurred at the position of the negative terminal - of the battery rack 110 if the relative position Pos of the insulation defect is 0%. The insulation resistance meter 530 may determine that insulation defect has occurred at the middle position between the negative terminal - of the battery rack 110 and the positive terminal + of the battery rack 110 if the relative position Pos of the insulation defect is 50%. The insulation resistance meter 530 may determine that an insulation defect has occurred at the position of the positive terminal + of the battery rack 110 if the relative position Pos of the insulation defect is 100%.

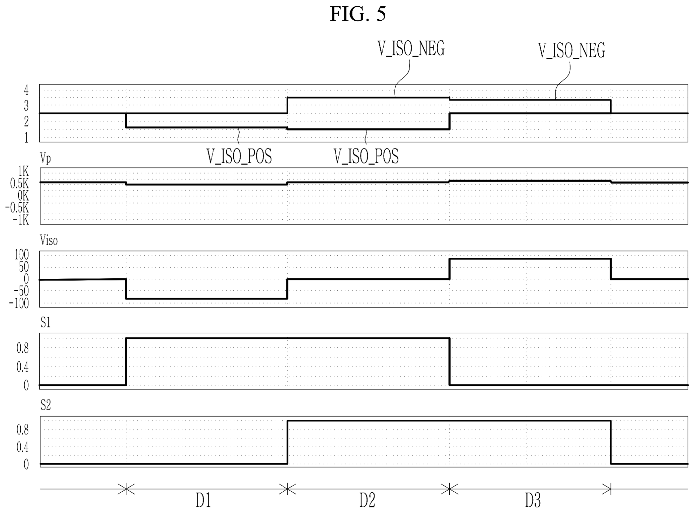

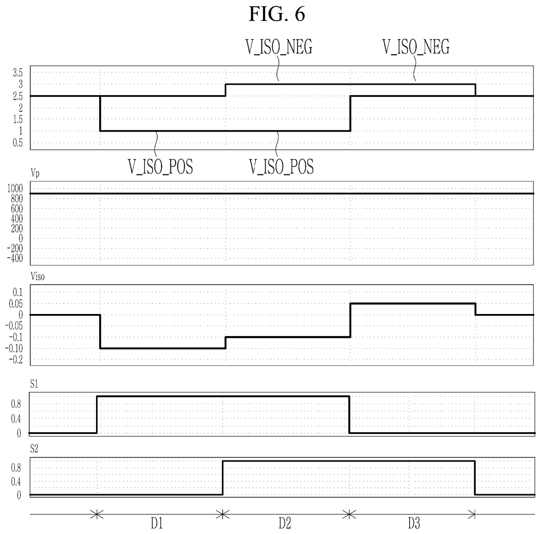

FIGS. 5 and 6 are diagrams showing simulation results of insulation defect detection of a battery insulation defect detection apparatus according to embodiments, respectively.

FIG. 5 shows the simulation result of insulation defect detection by an insulation defect detection apparatus if an insulation defect of 500 kΩ occurs at the middle position (relative position Pos of the insulation defect=50%) between the negative terminal - of the battery rack 110 and the positive terminal - of the battery rack 110.

FIG. 6 shows the simulation result of insulation defect detection by an insulation defect detection apparatus if an insulation defect of 500Ω occurs at a position of 1/4 distance (relative position Pos of the insulation defect=25%) from the position of the negative terminal - of the battery rack 110.

For the insulation defect detection simulation shown in FIGS. 5 and 6, the parameter values of the insulation defect detection apparatus 500 were set as shown in Table 1.

(Table 1)

| | |
|---|---|
| Vbat | 1200V |
| Rs1 | 5100Ω |
| Rps1 | 3000000Ω |
| Rps2 | 10000Ω |
| Rs2 | 5100Ω |

(continued)

| Vbat | 1200V |
|------|-------|
| Rns1 | 3000000Ω |
| Rns2 | 10000Ω |
| Vref | 2.5V |

First, referring to FIG. 5, the voltages measured in the first duration D1, the second duration D2, and the third duration D3 in the simulation results of insulation defect detection were shown in Table 2, and the relative position Pos of insulation defect calculated using the voltages shown in Table 2 was shown in Table 3.

(Table 2)

| | First duration | Second duration | Third duration |
|---|---|---|---|
| V_ISO_POS | 1.631825 | 1.4865534 | - |
| V_ISO_NEG | - | 3.5197554 | 3.37539 |

Using the voltage V_ISO_POS of the first duration D1 and the voltage V_ISO_NEG of the third duration D3 shown in Table 2 and Equation 1, the insulation resistance Riso may be calculated as 500.050 kΩ, as shown in Table 3. In addition, using the voltage V_ISO_POS and V_ISO_NEG of the second duration D2 shown in Table 2 and Equation 3, the voltage Vp between the positive terminal + of the battery rack 110 and the ground in the event of a ground fault may be calculated as 600.6322 V, as shown in Table 3. The ground fault voltage Viso may be is calculated as 0.618571 V based on Equation 4, and the relative position Pos of the insulation defect may be calculated as 50% based on Equation 2, using the battery voltage of 1200 V, the voltage Vp of 600.6322 V, and the ground fault voltage Viso of 0.618571 V.

(Table 3)

| Riso | 500.050kΩ |
|------|-----------|
| Vp | 600.6322V |
| Viso | 0.618571V |
| Pos | 50% |

The relative position Pos of the insulation defect of 50% indicates that the insulation defect has occurred at the middle position between the negative terminal - of the battery rack 110 and the positive terminal + of the battery rack 110, and it may be seen that the insulation defect detection apparatus 500 according to the embodiment accurately detects the position of the insulation defect.

Next, referring to FIG. 6, the voltages measured in the first duration D1, the second duration D2, and the third duration D3 in the simulation results of insulation defect detection were shown in Table 4, and the relative position Pos of insulation defect calculated using the voltages shown in Table 2 was shown in Table 5.

(Table 4)

| | First duration | Second duration | Third duration |
|---|---|---|---|
| V_ISO_POS | 0.979562 | 0.97947664 | - |
| V_ISO_NEG | - | 3.0126789 | 3.012426 |

Using the voltage V_ISO_POS of the first duration D1 and the voltage V_ISO_NEG of the third duration D3 shown in Table 4 and Equation 1, the insulation resistance Riso may be calculated as 0.531 kΩ, as shown in Table 5. In addition, using the voltage V_ISO_POS and V_ISO_NEG of the second duration D2 shown in Table 4 and Equation 3, the voltage Vp between the positive terminal + of the battery rack 110 and the ground in the event of a ground fault may be calculated as 899.9069 V, as shown in Table 5. The ground fault voltage Viso may be is calculated as - 0.10484 V based on Equation 4, and the relative position Pos of the insulation defect may be calculated as 25% based on Equation 2, using the battery voltage of 1200 V, the voltage Vp of 899.9069 V, and the ground fault voltage Viso of -0.10484 V.

(Table 5)

| Riso | 0.531kΩ |
|---|---|
| Vp | 899.9069V |
| Viso | -0.10484V |
| Pos | 25% |

The relative position Pos of the insulation defect of 25% indicates that an insulation defect has occurred at a position of 1/4 distance from the position of the negative terminal - of the battery rack 110 between the negative terminal - of the battery rack 110 and the positive terminal + of the battery rack 110, and it may be seen that the insulation defect detection apparatus 500 according to the embodiment accurately detects the position of the insulation defect.

In this way, the insulation defect detection apparatus 500 according to the embodiment may detect the insulation status of the battery rack 110 and the position of the insulation defect in the case of an insulation defect of the battery rack 110.

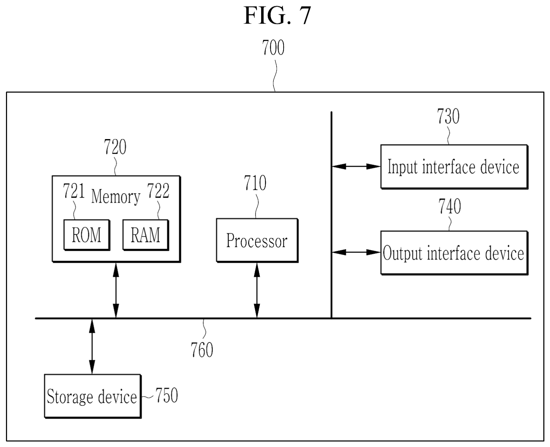

FIG. 7 is a diagram showing a battery insulation defect detection apparatus according to embodiments.

Referring to FIG. 7, the battery insulation defect detection apparatus 700 may represent a computing device in which the battery insulation defect detection method described herein is implemented.

The battery insulation defect detection apparatus 700 may include at least one of processor 710, a memory 720, an input interface device 730, an output interface device 740, and a storage device 750. Each component is connected to a bus 760 and may communicate with each other. In addition, each component may be connected through an individual interface or individual bus centered on the processor 710, rather than the common bus 760.

The processor 710 may be implemented as various types such as an application processor (AP), a central processing unit (CPU), a graphics processing unit (GPU), etc., and may be any semiconductor device that executes a command stored in the memory 720 or storage device 750. The processor 710 may perform the insulation defect detection function described with reference to FIGS. 1 to 6 by executing program commands stored in at least one of the memory 720 and the storage device 750.

The memory 720 and storage device 750 may include various forms of volatile or non-volatile storage media. For example, the memory 720 may include a read-only memory (ROM) 721 and a random access memory (RAM) 722. Inembodiments, the memory 720 may be located inside or outside the processor 710, and the memory 720 may be connected to the processor 710 via various means already known.

The input interface device 730 may be configured to provide data to the processor 710. In some embodiments, the input interface device 730 may provide the voltages measured by the first voltage meter 510 and the second voltage meter 520 to the processor 710.

The output interface device 740 may be configured to output data from the processor 710. In some embodiments, the output interface device 740 may output insulation status information of the battery rack 110 and the position of insulation defect in the event of insulation defect of the battery rack 110.

According to at least embodiments, the insulation status of a battery rack and the position of an insulation defect in the case of an insulation defect of the battery rack may be detected using resistors and operational amplifiers, and the work time required to detect the position of the insulation defect may be reduced.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated.

**Claims**

1. A method for detecting an insulation defect in a battery comprising:

   measuring a first voltage corresponding to a voltage of a positive terminal of a battery rack (110) during a first duration (D1);
   measuring a second voltage corresponding to the voltage of the positive terminal of the battery rack (110) and a third voltage corresponding to a voltage of a negative terminal of the battery rack (110), respectively, during a second duration (D2);
   measuring a fourth voltage corresponding to the voltage of the negative terminal of the battery rack (110) during a third duration (D3);

measuring an insulation resistance value of the battery rack (110) based on the first voltage and the fourth voltage; and

determining whether the battery rack (110) has the insulation defect based on the insulation resistance value of the battery rack (110).

2. The method as claimed in claim 1, further comprising:
detecting a position of the insulation defect in the battery rack (110) using the second voltage and the third voltage if the battery rack (110) is determined to have defective insulation.

3. The method as claimed in claim 2, wherein
the detecting a position of the insulation defect comprises:

calculating a ground fault voltage using the second voltage, the third voltage, and the insulation resistance value;
calculating a voltage between the positive terminal of the battery rack (110) and ground using the ground fault voltage and the second voltage;
calculating a relative position of the insulation defect using the ground fault voltage and the voltage between the positive terminal of the battery rack (110) and ground; and
specifying the position of the insulation defect from the relative position of the insulation defect.

4. The method as claimed in claim 3, wherein the relative position of the insulation defect indicates a ratio of a distance between the negative terminal of the battery rack (110) and the positive terminal of the battery rack (110) and a distance from a position of the negative terminal of the battery rack (110) to the position of the insulation defect, as a percentage (%).

5. The method as claimed in claim 4, wherein
the specifying a position of the insulation defect comprises:

if the relative position of the insulation defect is 0%, specifying the position of the negative terminal of the battery rack (110) as the position of the insulation defect;
if the relative position of the insulation defect is 100%, specifying the position of the positive terminal of the battery rack (110) as the position of the insulation defect; and
if the relative position of the insulation defect is 50%, specifying a middle position between the negative terminal of the battery rack (110) and the positive terminal of the battery rack (110) as the position of the insulation defect.

6. The method as claimed in any one of the preceding claims, wherein:

the measuring the first voltage during the first duration comprises turning on a first switch (310) connected between the positive terminal of the battery rack (110) and an inverting input terminal of a first operational amplifier (512, 522),
the measuring the fourth voltage during the third duration comprises turning on a second switch (320) connected between the negative terminal of the battery rack (110) and an inverting input terminal of a second operational amplifier (512, 522), and
measuring the second voltage and the third voltage during the second duration comprises turning on the first switch (310) and the second switch (320) simultaneously.

7. An insulation defect detection apparatus (500) comprising:

a first voltage meter (510) configured to measure a voltage of a positive terminal of a battery rack (110);
a second voltage meter (520) configured to measure a voltage of a negative terminal of the battery rack (110);
a controller (540) configured to measure the voltage of the positive terminal as a first voltage during a first duration, measure the voltage of the positive terminal and the voltage of the negative terminal as a second voltage and a third voltage respectively during a second duration, and measure the voltage of the negative terminal as a fourth voltage during a third duration; and
an insulation resistance meter (530) configured to detect an insulation status of the battery rack (110) using the first voltage, the second voltage, the third voltage, and the fourth voltage.

8. The insulation defect detection apparatus (500) as claimed in claim 7, wherein the insulation resistance meter (530) is configured to measure an insulation resistance value of the battery rack (110) based on the first voltage and the fourth voltage, and determine that an insulation of the battery rack (110) is defective if the insulation resistance value of the battery rack (110) is lower than or equal to a set threshold value.

9. The insulation defect detection apparatus (500) as claimed in claim 8, wherein the insulation resistance meter (530) is configured to detect a position of an insulation defect in the battery rack (110) using the second voltage and the third voltage if the battery rack (110) is determined to have defective insulation based on the insulation resistance value of the battery rack (110).

10. The insulation defect detection apparatus (500) as claimed in claim 9, wherein the insulation resistance meter (530) is configured to calculate a ground fault voltage using the second voltage, the third voltage, and the insulation resistance value, calculate a voltage between the positive terminal of the battery rack (110) and ground using the ground fault voltage and the second voltage, calculate a relative position of the insulation defect using the ground fault voltage and the voltage between the positive terminal of the battery rack (110) and ground, and specify the position of the insulation defect from the relative position of the insulation defect.

11. The insulation defect detection apparatus (500) as claimed in claim 10, wherein the relative position of the insulation defect indicates a ratio of a distance between the negative terminal of the battery rack (110) and the positive terminal of the battery rack (110) and a distance from a position of the negative terminal of the battery rack (110) to the position of the insulation defect, as a percentage (%).

12. The insulation defect detection apparatus (500) as claimed in claim 11, wherein the insulation resistance meter (530) is configured specify the position of the negative terminal of the battery rack (110) as the position of the insulation defect if the relative position of the insulation defect is 0%, specify the position of the positive terminal of the battery rack (110) as the position of the insulation defect if the relative position of the insulation defect is 100%, and specify a middle position between the negative terminal of the battery rack (110) and the positive terminal of the battery rack (110) as the position of the insulation defect if the relative position of the insulation defect is 50%.

13. The insulation defect detection apparatus (500) as claimed in claim 10, wherein:

the first voltage meter (510) is configured to comprise a first operational amplifier (512, 522) and a first switch (310) connected between a first input terminal of the first operational amplifier (512, 522) and the positive terminal of the battery rack (110),
the second voltage meter (520) is configured to comprise a second operational amplifier (512, 522) and a second switch (320) connected between a second input terminal of the second operational amplifier (512, 522) and the negative terminal of the battery rack (110), and
the controller (540) is configured to turn on only the first switch (310) during the first duration, maintain an on state of the first switch (310) and turn on the second switch (320) during the second duration, and turn off the first switch (310) and maintain an on state of the second switch (320) during the third duration.

14. A battery system (100) comprising:

a battery rack (110) configured to comprise a plurality of battery cells; and
a rack battery management system, RBMS, (120) configured to measure a voltage of a positive terminal as a first voltage during a first duration, measure the voltage of the positive terminal and a voltage of a negative terminal as a second voltage and a third voltage respectively during a second duration after the first duration, measure the voltage of the negative terminal as a fourth voltage during a third duration after the second duration, and detect an insulation status of the battery rack (110) using the first voltage, the second voltage, the third voltage, and the fourth voltage.

15. The battery system (100) as claimed in claim 14, wherein the rack battery management system (120) is configured to measure an insulation resistance value of the battery rack (110) based on the first voltage and the fourth voltage, and determine that an insulation of the battery rack (110) is defective if the insulation resistance value of the battery rack (110) is lower than or equal to a set threshold value.

FIG. 1

# FIG. 2

FIG. 3

# FIG. 4

Obtain voltages measured by first voltage meter and second voltage meter in first duration, second duration, and third duration — S402

Calculate insulation resistance of battery rack by using voltage measured by first voltage meter in first duration and voltage measured by second voltage meter in third duration — S404

S406

Insulation resistance > Threshold value?

Yes

No

S410

Diagnose that insulation status of battery rack is normal

Diagnose that insulation status of battery rack is defective — S408

Calculate ground fault voltage, using voltages measured by first voltage meter and second voltage meter in second duration and insulation resistance value — S412

Calculate voltage between positive terminal of battery rack and ground in event of ground fault by using ground fault voltage and voltage measured by e first voltage meter in second duration — S414

Calculate relative position of insulation defect using ground fault voltage and voltage between positive between positive terminal of battery rack and ground — S416

Specify position of insulation defect based on relative position of insulation defect — S418

FIG. 5

EP 4 737 928 A1

## FIG. 6

## FIG. 7

Europäisches
Patentamt

European
Patent Office

Office européen
des brevets

## EUROPEAN SEARCH REPORT

**Application Number**

EP 25 20 8044

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 102 302 941 B1 (ITSCIENCECORP CO LTD [KR]) 16 September 2021 (2021-09-16) | 1-7, 13-15 | INV.<br>G01R31/396<br>G01R31/52<br>H01M10/48 |
| A | * figures 3,11 *<br>* claim 1 *<br>* paragraph [0047] - paragraph [0050] *<br>* paragraph [0052] *<br>* paragraph [0035] * | 9-12 | |
| X | US 2022/283231 A1 (HAM SANG-HYEOK [KR] ET AL) 8 September 2022 (2022-09-08) | 1,7-12 | |
| A | * figures 2-3 *<br>* paragraph [0133] * | 15 | |
| X | US 2022/203838 A1 (HAM SANG-HYEOK [KR]) 30 June 2022 (2022-06-30)<br>* figure 2 * | 1,7 | |

**TECHNICAL FIELDS SEARCHED (IPC)**

G01R
B60L
H01M

The present search report has been drawn up for all claims

| Place of search | Date of completion of the search | Examiner |
|---|---|---|
| The Hague | 2 March 2026 | Rambaud, Patrick |

EPO FORM 1503 03.82 (P04C01)

**EP 4 737 928 A1**

## ANNEX TO THE EUROPEAN SEARCH REPORT
## ON EUROPEAN PATENT APPLICATION NO.

EP 25 20 8044

02-03-2026

| Patent document cited in search report | Publication date | Patent family member(s) | | Publication date |
|---|---|---|---|---|
| KR 102302941 B1 | 16-09-2021 | NONE | | |
| US 2022283231 A1 | 08-09-2022 | CN | 113874738 A | 31-12-2021 |
| | | EP | 3988372 A1 | 27-04-2022 |
| | | ES | 2998450 T3 | 20-02-2025 |
| | | HU | E069448 T2 | 28-03-2025 |
| | | JP | 7323260 B2 | 08-08-2023 |
| | | JP | 2022524032 A | 27-04-2022 |
| | | US | 2022283231 A1 | 08-09-2022 |
| | | WO | 2021085885 A1 | 06-05-2021 |
| US 2022203838 A1 | 30-06-2022 | CN | 113795763 A | 14-12-2021 |
| | | EP | 3981637 A1 | 13-04-2022 |
| | | JP | 7248221 B2 | 29-03-2023 |
| | | JP | 2022524031 A | 27-04-2022 |
| | | US | 2022203838 A1 | 30-06-2022 |
| | | WO | 2021085893 A1 | 06-05-2021 |

EPO FORM P0459